# EUROPEAN PATENT APPLICATION

(11) **EP 4 794 509 A1**
(43) Date of publication of application: **19.08.2026**
(21) Application number: 25214177.5
(22) Date of filing: 07.11.2025
(51) Int. Cl.: H10P 90/00

(54) **METHOD OF MANUFACTURING SILICON ON INSULATOR SUBSTRATE**

(30) Priority: 18.02.2025 KR 20250020913
(71) Applicant: SK hynix Inc., Bubal-eub Icheon-si Gyeonggi-do 17336 (KR)
(72) Inventor: KIM, Hyo Jeong, 17336 Icheon-si, Gyeonggi-do (KR); KIM, Il Do, 17336 Icheon-si, Gyeonggi-do (KR); PARK, Sang Mee, 17336 Icheon-si, Gyeonggi-do (KR); KIM, Seung Bum, 17336 Icheon-si, Gyeonggi-do (KR)
(74) Representative: Isarpatent

(57) **Abstract**

A method of manufacturing a silicon on insulator (SOI) substrate is provided. A method of forming an SOI substrate includes forming a first wafer structure on an upper surface of a first wafer having a notch and a wafer identification (ID). The first wafer structure includes an etch stopper, a semiconductor layer, a buried insulation layer and a first bonding insulation layer, which are sequentially formed. An edge of the first wafer structure may be trimmed to form a trimmed region. Residual trimming byproducts on the first bonding insulation layer of the first wafer structure may be removed. The first wafer structure may be bonded to the second wafer structure. The semiconductor layer of the first wafer structure may be transferred onto the second wafer structure. A trimmed region may have a width greater than a recess length of the notch, and a depth greater than a depth of the wafer ID.

## Description

### BACKGROUND

### 1. Technical Field

Embodiments of the present disclosure relate to a semiconductor manufacturing technology, and more particularly to a method of manufacturing a silicon on insulator (SOI) substrate with a semiconductor layer having a uniform thickness.

### 2. Related Art

A semiconductor memory device such as a dynamic random access memory (DRAM) device may be required to have high integration densities while satisfying high operating speed characteristics.

To improve the integration density of current DRAM devices, a technology utilizing a vertical channel transistor as a cell switching element has been proposed. The vertical channel transistor may be required to be formed on an SOI substrate with a semiconductor layer having a uniform thickness to ensure uniform memory cell characteristics and perfect isolation between adjacent vertical channel transistors. The SOI substrate may be formed by bonding a donor wafer and a carrier wafer including a semiconductor layer. Consequently, a uniformity of the semiconductor layer may be affected by the bonding characteristics between the donor wafer and the carrier wafer.

### SUMMARY

Example embodiments provide a method of manufacturing a SOI substrate with improved bonding properties.

According to example embodiments, there may be provided a method of manufacturing a SOI substrate. In the method of manufacturing the SOI substrate, an etch stopper, a semiconductor layer, a buried insulation layer and a first bonding insulation layer may be sequentially formed on an upper surface of a first wafer to form a first wafer structure, wherein the first wafer includes a notch and a wafer identification (ID) formed at an edge of the first wafer. An edge of the first wafer structure may be trimmed to form a trimming region. Residual trimming byproducts on the first bonding insulation layer of the first wafer structure may then be removed. The first wafer structure may be bonded to a second wafer structure. The semiconductor layer of the first wafer structure may be transcribed onto the second wafer structure. A width of the trimmed region may be greater than a recess length of the notch and a length of the wafer ID. A depth of the trimmed region may be greater than a depth of the wafer ID.

According to example embodiments, there may be provided a method of manufacturing a SOI substrate. In the method of manufacturing the SOI substrate, an etch stopper, a semiconductor layer, a buried insulation layer and a first bonding insulation layer may be sequentially formed on a first wafer having a notch and a wafer identification (ID) formed on an edge of the first wafer to form a first wafer structure. An edge of the first wafer structure may be removed so that the notch and wafer ID may be removed, forming a trimmed region. Residual trimming byproducts of the first bonding insulation layer of the first wafer structure may be removed. A second bonding insulation layer may be formed on the second wafer to form a second wafer structure. The first wafer structure and the second wafer structure may be bonded to each other such that the first bonding insulation layer and the second bonding insulation layer may face each other. The first wafer and the etch stopper of the first wafer structure may then be removed.

In some embodiments, the trimmed region may have a width of about 2.1 mm to about 2.3 mm. The trimmed region may have a depth of about 75 µm to about 85 µm from the first bonding insulation layer to the inside of the first wafer.

In some embodiments, the removing of the edge of the first wafer structure may include irradiating a laser beam on an upper surface of the first wafer structure to form a modification region, and applying a shear force in a thickness direction of the first wafer structure to the modification region to remove the edge of the first wafer structure.

In some embodiments, the removing of the trimming byproduct may include chemical mechanical polishing (CMP) a portion of a thickness of the first bonding insulation layer of the first wafer structure, and cleaning CMP byproducts generated during the CMP.

In some embodiments, the CMP may be performed using a slurry having abrasive particles including metal oxide of at least one of silica, ceria, zirconia, alumina, titania, barium titania, germanium, manganese and magnesia.

In some embodiments, the CMP byproducts may be cleaned using a cleaning solution including at least one of sulfuric peroxide mixture (SPM), hydrogen fluoride (HF) and an SC1 solution (NH₄OH:H₂O₂:H₂O= 1:1:5).

According to example embodiments, during the edge trimming operation of the first wafer structure, the notch and the wafer ID of the wafer may be removed by the trimmed region. Accordingly, trimming byproducts may be prevented from becoming stuck in the recesses of the wafer notches and wafer IDs, thereby improving poor bonding.

### BRIEF DESCRIPTION OF THE DRAWINGS

The above and another aspects, features and advantages of the subject matter of the present disclosure will be more easily understood from the following detailed description taken in conjunction with the accompanying drawings, in which:
FIG. 1 is a flow chart illustrating a method of manufacturing a SOI substrate in accordance with the embodiment of the present disclosure;
FIG. 2 is a flow chart illustrating a method of forming a first wafer structure in accordance with the embodiment of the present disclosure;
FIGS. 3A to 3C are cross-sectional views of each process to illustrate a method of forming a first wafer structure in accordance with the embodiment of the present disclosure;
FIG. 4 is a perspective view illustrating a wafer processing apparatus in accordance with the embodiment of the present disclosure;
FIG. 5 is an enlarged plan view of the wafer taken along a portion "A" of FIG. 4 in accordance with the embodiment of the present disclosure;
FIG. 6 is a cross-sectional view illustrating an edge-trimmed first wafer structure in accordance with the embodiment of the present disclosure;
FIG. 7 is a flow chart illustrating an edge trimming process in accordance with the embodiment of the present disclosure; and
FIG. 8 is a flow chart illustrating removing trimming byproducts in accordance with the embodiment of the present disclosure.

### DETAILED DESCRIPTION

The advantages and features of the present invention, and methods of achieving them, will become apparent upon reference to the embodiments described in detail with reference to the accompanying drawings. However, the invention is not limited to the embodiments disclosed herein, but will be embodied in many different forms, and these embodiments are provided merely to make the disclosure of the invention complete and to give a complete picture of the scope of the invention to one of ordinary skill in the technical field to which the invention belongs, and the invention is defined by the scope of the claims. The dimensions and relative sizes of the layers and regions in the drawings may be exaggerated for clarity of description. Throughout the specification, like reference numerals refer to like components.

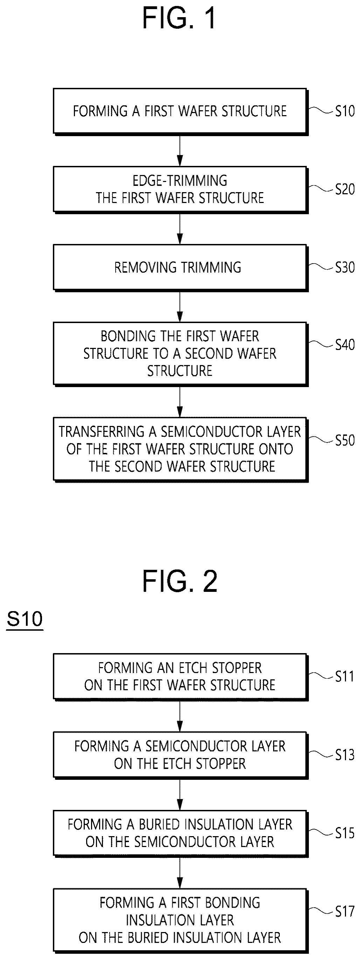

Referring to FIG. 1, a SOI substrate may be fabricated by forming a first wafer structure including a semiconductor layer (S10), edge-trimming the first wafer structure (S20), removing trimming byproducts on the first wafer structure (S30), bonding the first wafer structure to a second wafer structure (S40), and transferring the semiconductor layer of the first wafer structure onto the second wafer structure (S50).

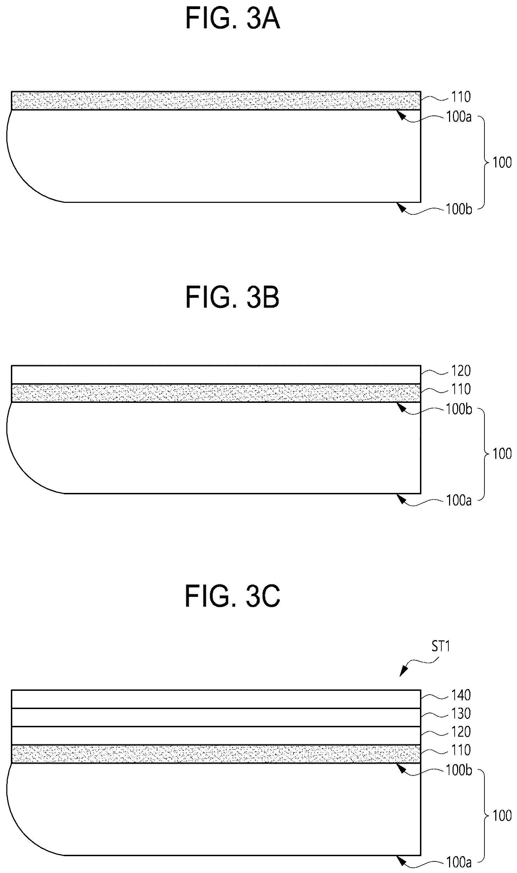

More specifically, referring to FIGS. 1, 2, and 3A, the forming the first wafer structure (S10) may include forming an etch stopper 110 on a first wafer 100 (S11).

The first wafer 100 may include a first surface 100a and a second surface 100b which are opposite. For example, the first surface 100a may be an upper surface of the first wafer 100. The first wafer 100 may be a donor wafer that will be removed. The first wafer 100 may include at least one material selected from silicon (Si), germanium (Ge), silicon carbide (SiC), IV-IV group, III-V group, or II-VI group semiconductor compounds, and piezoelectric materials (e.g., lithium niobate (LiNbO₃), lithium tantalate (LiTaO₃), etc.).

An etch stopper 110 may be formed on the first surface 100a of the first wafer 100 to prevent loss of the semiconductor layer to be formed thereafter. The etch stopper 110 may include a material having an etch selectivity with the first wafer 100 and the semiconductor layer to be formed later, respectively.

In example embodiments, when the first wafer 100 may include an Si material, the etch stopper 110 may include a silicon germanium (SiGe) material. The etch stopper 110 including the SiGe material may be formed by an epitaxial growth process. The etch stopper 110 may be appropriately selected in consideration of a thickness of the semiconductor layer to be formed later.

Referring to FIGS. 1, 2, and 3B, the forming the first wafer structure (S10) may include forming a semiconductor layer 120 on the etch stopper 110 (S13). In example embodiments, the semiconductor layer 120 may include a region in which a channel of a transistor included in a semiconductor memory device may be formed. The semiconductor layer 120 may include, for example, a single crystalline Si material.

For example, the semiconductor layer 120 may be formed using an epitaxial growth process. The etch stopper 110 and the semiconductor layer 120 may be formed in an in-situ process with a vacuum interruption. For example, the semiconductor layer 120 may be formed to have a thickness of about 5nm to about 500nm, but is not limited thereto.

Referring to FIGS. 1, 2, and 3C, the forming the first wafer structure (S10) may include forming a buried insulation layer 130 on the semiconductor layer 120 (S15). The buried insulation layer 130 may include, for example, an SiO₂ material. However, the material of the buried insulation layer 130 is not limited to SiO₂.

Referring to FIGS. 1, 2, and 3C, the forming the first wafer structure (S10) may include forming a first bonding insulation layer 140 on the buried insulation layer 130 (S17).

For example, the first bonding insulation layer 140 may include at least one of silicon carbon nitride (SiCN), silicon oxynitride (SiON), and silicon nitride (SiN) materials. However, the first bonding insulation layer 140 is not limited to the above materials, and various insulation layers having bonding properties may be included herein. Thereby, the first wafer structure ST1 may be formed.

Next, the edge trimming operation S20 of the first wafer structure ST1 may be performed in a wafer processing apparatus.

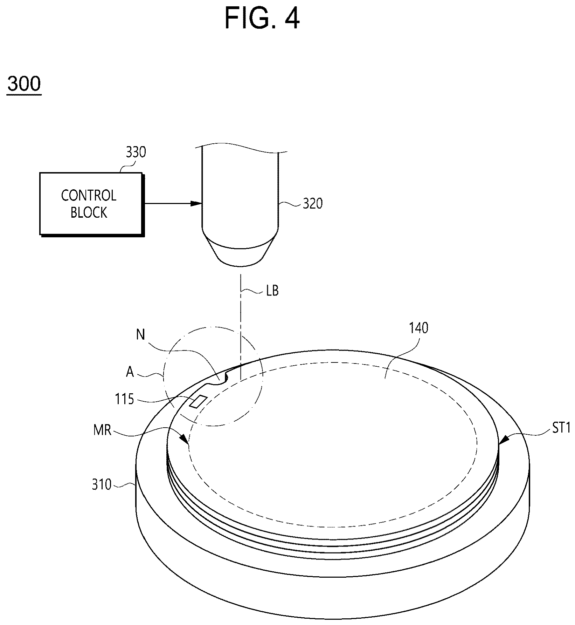

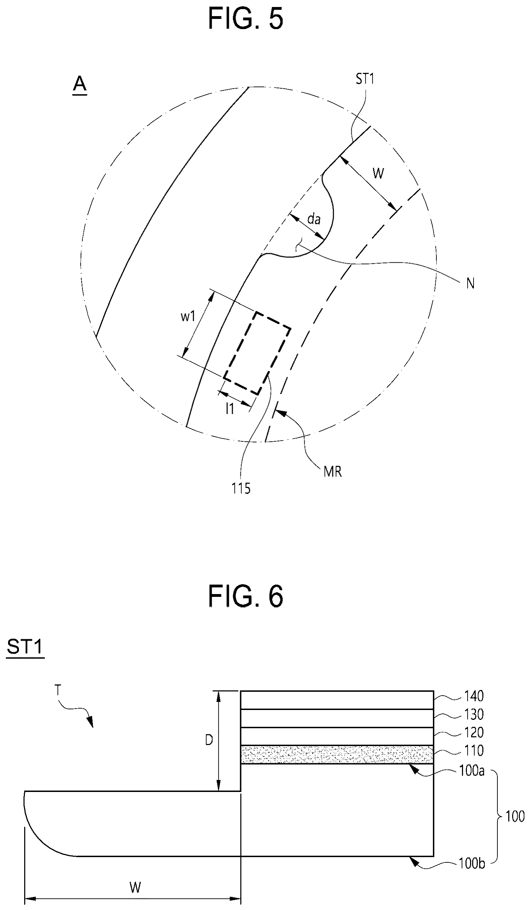

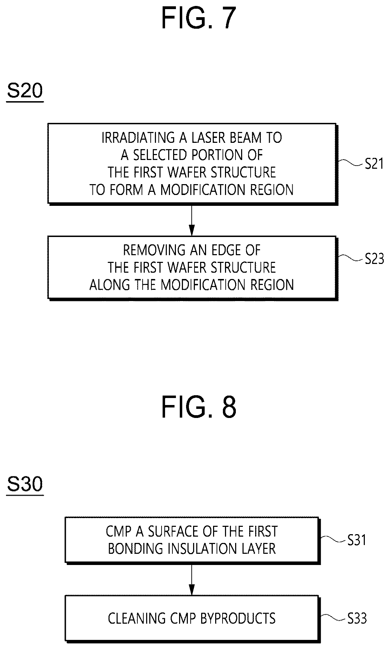

FIG. 4 is a perspective view illustrating a wafer processing apparatus in accordance with example embodiments, FIG. 5 is an enlarged plan view of a wafer illustrating a portion "A" of FIG. 4, FIG. 6 is a cross-sectional view illustrating an edge-trimmed first wafer structure in accordance with example embodiments, and FIG. 7 is a flow chart illustrating an edge trimming process in accordance with example embodiments.

Referring to FIGS. 1, 4, and 7, the wafer processing apparatus 300 may be, for example, a laser processing apparatus. The wafer processing apparatus 300 may include a supporter 310, a laser irradiation block 320, a control block 330 and a compression block (not shown).

The first wafer structure ST1 may be loaded on the supporter 310. In other words, the supporter 310 may support the first wafer structure ST1. For example, the first wafer structure ST1 may be loaded on the supporter 310 with the first bonding insulation layer 140 facing upwardly.

The supporter 310 may be configured for horizontal, vertical, and rotational drive. The drive of the supporter 310 may be controlled by the control block 330.

The laser irradiation block 320 may irradiate a laser beam LB to selected locations of the first wafer structure ST1 to modify the selected locations of the first wafer structure ST1. A reference numeral MR of FIG. 4 may indicate a modification region in which a property of the first wafer structure ST1 may be modified by the laser beam LB.

The compression block may impart a shear force in a thickness (or depth) direction to the first wafer structure ST1. Based on the shear force applied by the compression block, an edge of the first wafer structure ST1 along the modification region MR may be removed to form a trimmed (or trimming) region T.

In example embodiments, the edge trimming operation (S20) may include irradiating the first wafer structure ST1 with a laser beam LB directed to selected locations of the first wafer structure ST1 to form the modified region MR (S21), as shown in FIG. 7. The edge trimming operation (S20) may include removing an edge region of the first wafer structure ST1 along the modified region MR by applying an external force, for example, the shear force, applied by the compression block (S23).

In this manner, by removing the edge region of the first wafer structure ST1, the trimming region T may be formed on the edge of the first wafer structure ST1.

As shown in FIG. 5, a width W of the trimming region T may be greater than a recess length da of the notch N of the first wafer 100 and a length 11 of a wafer identification (ID) 115. In example embodiments, when the recess length da of the notch N of the first wafer 100 may be between about 1.0 µm and about 1.5 µm and the length l1 of the wafer ID 115 may be between about 50 µm and about 100 µm, the width W of the trimming region T may be between about 2.1 mm and about 2.3 mm.

Further, a depth D of the trimming region T may be between about 75 µm and about 85 µm when measured with respect to (a depth of) the wafer ID 115. In other words, the trimming region T may be disposed at between about 75 µm and about 85 µm below the upper surface the wafer ID 115 (i.e., the first bonding insulation layer 140).

Traditionally, an edge of a wafer may be chamfered. However, in these SOI substrate fabrication processes, there may be undesirable effects when a wafer grinding process is carried out, particularly as the edge of the chamfered wafer may be sharpened into a knife shape (for example, a knife edge). Since the knife edges may cause cracks in the wafer, a wafer edge trimming process may be proposed (or recommended, desired, etc.) to prevent the generation of the knife edges.

Elsewhere on the wafer 100, the notch N and the wafer ID 115 may be formed on the edge of the first wafer 100.

The notch N may have the recess length da inwardly of the wafer, through which a direction of crystal growth of the first wafer 100 may be determined.

The wafer ID 115 may include information about the first wafer 100. For example, the wafer ID 115 may indicate a manufacturing history of the wafer, manufacturing conditions of the wafer and characteristics of the wafer, including data on single crystal ingot lifting, slicing, and lapping. For example, the wafer ID 115 may include letters, numbers, a linear code, or a two-dimensional code. In example embodiments, the letters, the numbers, the linear code, or the two-dimensional code included in the wafer ID 115 may include an array of dots having a width of about 3 µm to about 5 µm and a depth of about 0.5 µm to about 1 µm. The wafer ID 115 may be formed by a laser marking method. Further, the two-dimensional code may be a matrix of 8 x 32 dots, or 16 x 16 dots for displaying data about the wafer and the product. The wafer ID 115 may be formed, for example, on the first surface 100a of the first wafer 100 with a predetermined depth.

However, in instances in which the width of the trimming region is smaller than the recess length da of the notch N or the length 11 of the wafer ID 115, or those in which the depth of the trimming region is configured to expose a bottom portion of the wafer ID 115 (e.g., a bottom portion of a laser mark), trimming byproducts may be trapped in the notch N and in the recess portion of the wafer ID 115. The trimming byproducts trapped in the recesses might not be easy to remove even in instances of application of subsequent CMP processes and cleaning processes. The trimming byproducts may be located (for example, embedded, ingrained) between the first wafer structure ST1 and the second wafer structure, causing poor bonding.

In example embodiments, the trimming region T may be formed to have the width W greater than the recess length daof the notch N and the length 11 of the wafer ID 115, and a depth D deeper than a location of the bottom of the wafer ID 115, in order to prevent bonding failure as described above.

Accordingly, when forming the trimming (or trimmed) region T, the notch N and the wafer ID 115 may be removed, thereby eliminating recesses in which the trimming byproducts may become trapped.

FIG. 8 is a flow chart illustrating removing trimming byproducts in accordance with example embodiments.

Referring to FIG. 8, the removing (of) the trimming byproducts on the first wafer structure ST1 (S30) may include the chemical mechanical polishing (CMP) (of) the surface of the first bonding insulation layer 140 of the first wafer structure ST1 to a certain (for example, predetermined target) thickness (S31).

As a result of the edge trimming S20 of the first wafer structure ST1, trimming byproducts may remain on the first bonding insulation layer 140. These trimming byproducts remaining on the surface of the first bonding insulation layer 140 may cause subsequent bonding failure, and may cause defects of the first bonding insulation layer 140.

Accordingly, the trimming byproducts and the defected first bonding insulation layer 140 may be removed via performing CMP process to reduce the structure to a predetermined thickness and remove trimming particles remaining on the first wafer structure ST1. For example, the abrasive particles in the CMP polishing slurry during the CMP process may include metal oxide of at least one of silica, ceria, zirconia, alumina, titania, barium titania, germanium, manganese, and magnesia. In example embodiments, the polishing slurry may be a material capable of having a zero charge surface zeta potential utilizing a variety of cleaning materials. The CMP performed on the first wafer structure ST1 may include a touch CMP method.

According to an embodiment, the removing the trimming byproduct on the first wafer structure ST1 (S30) may further include cleaning CMP byproducts on the first wafer structure ST1 (S33). The cleaning the CMP byproducts (S33) may utilize a cleaning solution of at least one of a sulfuric peroxide mixture (SPM), hydrogen fluoride (HF) and SC1 solution (NH₄OH:H₂O₂:H₂O= 1:1:5 (ammonium hydroxide: hydrogen peroxide: water)) to remove the CMP byproducts.

Referring again to FIG. 1, the bonding the first wafer structure to the second wafer structure (S40) may include forming a second bonding insulation layer on the second wafer.

The second wafer may be a carrier substrate. The second wafer may include at least one of Si, SiC, glass, sapphire, aluminum nitride (AlN) materials, or other materials available in substrate form, for example. The second bonding insulation layer may include a material capable of bonding with the first bonding insulation layer 140, such as an insulator having the same coefficient of thermal expansion as the first bonding insulation layer 140. In example embodiments, the second bonding insulation layer may include at least one of SiCN, SiO₂, and silicon nitride (Si₃N₄) materials, the same as the first bonding insulation layer 140.

Subsequently, the bonding (of) the first wafer structure ST1 to the second wafer structure may include stacking the first wafer structure ST1 on the second wafer structure such that a first bonding insulation layer 140 of the first wafer structure ST1 and a second bonding insulation layer of the second wafer structure may face each other, and then bonding the first wafer structure ST1 to the second wafer structure.

Next, the transferring of the semiconductor layer 120 onto the second wafer structure (S50) may include sequentially removing the first wafer 100 of the first wafer structure ST1 and the edge stopper 110. Accordingly, the semiconductor layer 120 located on the first wafer structure ST1 may be transposed onto the second wafer structure to complete a SOI substrate.

According to embodiments of the present disclosure, during the edge trimming operation of the first wafer structure, the notches and the wafer IDs of the wafer may be removed by the trimming region. Accordingly, the trimming byproducts may be prevented from becoming stuck in the recesses of the wafer notches and the wafer IDs, thereby reducing poor bonding (or bonding impediments) and improving bonding.

While the present invention has been described in detail with reference to preferred embodiments, the invention is not limited to the above embodiments, but is capable of many modifications by those having ordinary skill in the art within the scope of the technical ideas of the invention.

## Claims

1. A method of manufacturing a silicon on insulator (SOI) substrate, the method comprising:
forming a first wafer structure by sequentially forming an etch stopper, a semiconductor layer, a buried insulation layer, and a first bonding insulation layer on an upper surface of a first wafer, wherein the first wafer includes a notch and a wafer identification (ID) formed on an edge of the first wafer;
trimming an edge of the first wafer structure to form a trimmed region;
removing residual trimming byproducts of the first bonding insulation layer from the first wafer structure;
bonding the first wafer structure to a second wafer structure; and
transferring the semiconductor layer of the first wafer structure onto the second wafer structure,
wherein a width of the trimmed region is greater than a recess length of the notch and a length of the wafer ID, and a depth of the trimmed region is greater than a depth of the wafer ID.

2. The method of claim 1, wherein the trimmed region has the width of 2.1 mm to 2.3 mm, and the trimmed region has the depth of 75 µm to 85 µm from the first bonding insulation layer to the inside of the first wafer.

3. The method of claim 1, wherein the trimming of the edge of the first wafer structure comprises:
irradiating a laser beam onto the first wafer structure to form a modification region; and
removing the edge of the first wafer structure.

4. The method of claim 3, wherein the removing of the edge of the first wafer structure includes removing the edge of the first wafer structure by applying a shear force in a thickness direction of the first wafer structure to the modification region.

5. The method of claim 1, wherein the removing of the residual trimming byproducts comprises:
chemical mechanical polishing (CMP) a portion of the thickness of the first bonding insulation layer of the first wafer structure; and
cleaning CMP byproducts generated during the CMP.

6. The method of claim 5, wherein the CMP comprises a touch CMP process.

7. The method of claim 5, wherein the CMP is carried out using a slurry having abrasive particles including metal oxide of at least one of silica, ceria, zirconia, alumina, titania, barium titania, germanium, manganese, and magnesia.

8. The method of claim 1, wherein the second wafer structure comprises a second wafer and a second bonding insulation layer formed on the second wafer.

9. The method of claim 8, wherein the bonding of the first wafer structure to the second wafer structure comprises stacking and bonding the first wafer structure on the second wafer structure, to face the first bonding insulation layer with the second bonding insulation layer.

10. The method of claim 1, wherein the transferring of the semiconductor layer onto the second wafer structure comprises sequentially removing the first wafer of the first wafer structure and the etch stopper.

11. A method of manufacturing a silicon on insulator (SOI) substrate, the method comprising:
forming a first wafer structure by sequentially forming an etch stopper, a semiconductor layer, a buried insulation layer and a first bonding insulation layer on an upper surface of a first wafer, wherein the first wafer includes a notch and a wafer identification (ID) formed on an edge of the first wafer;
removing an edge of the first wafer structure, such that the notch and the wafer ID are removed, to form a trimmed region;
removing residual trimming byproducts of the first bonding insulation layer from the first wafer structure;
forming a second bonding insulation layer on a second wafer to form a second wafer structure;
bonding the first wafer structure to the second wafer structure such that the first bonding insulation layer and the second bonding insulation layer face each other; and
removing the first wafer of the first wafer structure and the etch stopper.

12. The method of claim 11, wherein the trimmed region has a width of 2.1 mm to 2.3 mm, and has a depth of 75 µm to 85 µm from the first bonding insulation layer to the inside of the first wafer.

13. The method of claim 11, wherein the removing of the edge of the first wafer structure comprises:
irradiating a laser beam onto the first wafer structure to form a modification region; and
removing the edge of the first wafer structure.

14. The method of claim 13, wherein the removing of the edge of the first wafer structure includes removing the edge of the first wafer structure by applying a shear force in a thickness direction of the first wafer structure to the modification region.

15. The method of claim 11, wherein the removing of the residual trimming byproducts comprises:
chemical mechanical polishing (CMP) a portion of the thickness of the first bonding insulation layer of the first wafer structure; and
cleaning CMP byproducts generated during the CMP.
